# EUROPEAN PATENT APPLICATION

(11) **EP 2 244 483 A2**
(43) Date of publication of application: **27.10.2010**
(21) Application number: 10160042.7
(22) Date of filing: 15.04.2010
(51) Int. Cl.: H04N 9/31

(54) **Image display apparatus and method for controlling the same**

(30) Priority: 20.04.2009 JP 2009101761
(71) Applicant: Funai Electric Co., Ltd., Daito-shi, Osaka 574-0013 (JP)
(72) Inventor: Nishioka, Ken, Daito-shi, Osaka 574-0013 (JP); Nagashima, Kenji, Daito-shi, Osaka 574-0013 (JP); Hirano, Atsuya, Daito-shi, Osaka 574-0013 (JP); Chikaoka, Atsuhiko, Daito-shi, Osaka 574-0013 (JP)
(74) Representative: Grünecker, Kinkeldey, Stockmair & Schwanhäusser Anwaltssozietät

(57) **Abstract**

An image display apparatus wherein reduction in contrast or resolution is prevented is provided. A laser projector as an embodiment of the image display apparatus includes a memory storing a threshold value predetermined for changing a driving mode of a laser light source, a calculator for calculating an optical power level for projecting an image, a driving-mode selector selecting a mode for driving the laser light source, a driving controller for sending a signal to the laser light source in accordance with a selected driving mode, and a laser emitter. The laser projector operates at least at a bias current value Ib or more. In this case, when the optical power level is lower than or equal to a predetermined threshold value TH, the laser projector emits pulsed light. When the optical power level based on a video signal exceeds threshold value TH, the laser projector changes the driving mode of laser light emission from pulsed light emission to DC light emission, to supply a current higher than or equal to bias current value Ib to each laser light source.

## Description

### BACKGROUND OF THE INVENTION

### Field of the Invention

The present invention relates to an image display apparatus, and more particularly to a technique for projecting an image using laser light.

### Description of the Background Art

Techniques for achieving gray-scale display with favorable contrast, resolution and linearity in an image display apparatus using laser light, generally called a laser projector, are disclosed in, for example, Japanese Patent Laying-Open Nos. 2007-121383, 2007-043067, 2007-004032, and 2001-189520.

Regarding control of a light source of an image display apparatus, Japanese Patent Laying-Open No. 2006-133558, for example, discloses a light source controller which facilitates display of an image of high resolution and an image having a large number of levels of gray scale, with an accurate gray scale. This light source controller controls driving of a light source part for supplying light modulated in accordance with an image signal. A light source controller 120 according to an aspect includes amplitude conversion parts 502 and 401 assigning at least one bit of the image signal and converting the amplitude of a pulse signal in accordance with the number of assigned bits and a pulse signal generating part 504 generating a pulse signal with the amplitude converted by amplitude conversion parts 502 and 401 (cf. SOLUTION of Abstract).

Japanese Patent Laying-Open No. 2008-103511 discloses a light-emitting element driving circuit, in which gamma correction can be performed accurately on a light-emitting element, such as a laser diode, on a relatively small circuit scale. According to this light-emitting element driving circuit, a light-intensity detection voltage DET of a laser diode 43 is generated, and reference voltages VREF0, VREF1, ..., and VREF2m-1, corresponding to changes from a minimum value to a maximum value of input video signals DIN0, DIN1, ..., and DINn-1, are set. Differential voltages CM0, CM1, ..., and CM2m-1 between the respective reference voltages and light-intensity detection voltage DET are generated. Since a driving current ILD is controlled based on a differential voltage corresponding to an input signal level at a current time point among these differential voltages, the output light intensity of laser diode 43 is always constant with respect to a certain input level, even if the temperature changes. Since the output light intensity of laser diode 43 has a gamma characteristic proportional to the power of 2.2 of an input video signal level, gamma correction is performed accurately (cf. SOLUTION of Abstract). Japanese Patent Laying-Open No. 2007-047355 discloses an optical scanner or the like capable of reducing the occurrence of crosstalk between adjacent pixels, for displaying a high-resolution image. This optical scanner irradiates a light beam in accordance with an image signal, and includes a light source part for supplying a light beam, and a scanning part for scanning a to-be-irradiated region with the light beam from the light source part in a first direction and a second direction which is substantially orthogonal to the first direction. The scanning part is driven so that the frequency at which scanning with the light beam is performed in the first direction is higher than the frequency at which scanning with the light beam is performed in the second direction. The light source part is driven so that a lighting time ton of a light beam for forming one pixel is not longer than the time during which scanning with the light beam is performed over the distance given by subtracting a length dx in the first direction of a spot SP formed by the light beam in the to-be-irradiated region from a length Px in the first direction of a pixel formed in accordance with the image signal (cf. SOLUTION of Abstract).

### SUMMARY OF THE INVENTION

According to an image display apparatus using a laser light source, optical power for displaying black light may increase, resulting in lower contrast. When optical power is at a lower level, light is diffused by spontaneous light emission, so that focusing on a spot cannot be obtained. The spot may therefore become larger than that during oscillation of the laser light source, resulting in lower resolution.

The present invention has been made to solve the above-described problems, and an object of the present invention is to provide an image display apparatus wherein reduction in contrast is prevented. Another object of the present invention is to provide an image display apparatus wherein reduction in resolution is prevented. Still another object of the present invention is to provide a method for controlling an image display apparatus wherein reduction in contrast is prevented. Still another object of the present invention is to provide a method for controlling an image display apparatus wherein reduction in resolution is prevented.

In summary, an image display apparatus according to an embodiment includes a laser light source, and a controller for controlling driving of the laser light source. The controller is configured to change a driving form of the laser light source based on an optical power level in accordance with data given to the apparatus for displaying an image and on a set threshold value.

Preferably, the controller is configured to drive the laser light source at a current value higher than or equal to a bias current value.

Preferably, the driving form includes a first driving mode and a second driving mode. The controller is configured to drive the laser light source in the first driving mode when the optical power level falls below the threshold value. The controller is configured to drive the laser light source in the second driving mode when the optical power level exceeds the threshold value.

According to another embodiment, a method for controlling an image display apparatus is provided. This method includes the steps of loading data for displaying an image onto the apparatus, and driving a laser light source by changing a driving form of the laser light source based on an optical power level in accordance with the data and on a set threshold value.

Preferably, the step of driving includes a step of driving the laser light source at a current value higher than or equal to a bias current value.

Preferably, the driving form includes a first driving mode and a second driving mode. The step of driving includes driving the laser light source in the first driving mode when the optical power level falls below the threshold value, and driving the laser light source in the second driving mode when the optical power level exceeds the threshold value.

Preferably, the first driving mode includes one of PAM (Pulse Amplitude Modulation) driving and PWM (Pulse Width Modulation) driving. The second driving mode includes one of PAM driving, PWM driving, and CW (Continuous Wave) driving. A duty ratio in the PAM driving as the second driving mode is higher than a duty ratio in the PAM driving as the first driving mode. A current value for the PWM driving as the second driving mode is higher than a current value for the PWM driving as the first driving mode.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a block diagram showing a configuration of a laser projector 10 which is a mode of an image display apparatus.
Fig. 2 is a block diagram showing a configuration of functions for implementing laser projector 10.
Fig. 3 is a block diagram showing a configuration of a driving controller 240 of laser projector 10.
Fig. 4 is a flow chart showing part of a series of process executed by a system controller 150 included in laser projector 10.
Fig. 5 shows a relationship between current value and optical power level in laser projector 10.
Fig. 6 shows differences between respective pixels in optical power level and current output value.
Fig. 7 shows driving properties when a bias current value Ib is used as a reference value for displaying an optical power level of black light.
Fig. 8 shows a case where a current value smaller than bias current value Ib is used for emitting black light.

### DESCRIPTION OF THE PREFERRED EMBODIMENTS

Hereinafter, embodiments of the present invention will be described with reference to the drawings. In the following, like components are denoted by like reference characters. They are named and function identically as well. Therefore, a detailed description thereof will not be repeated.

### [Hardware Configuration]

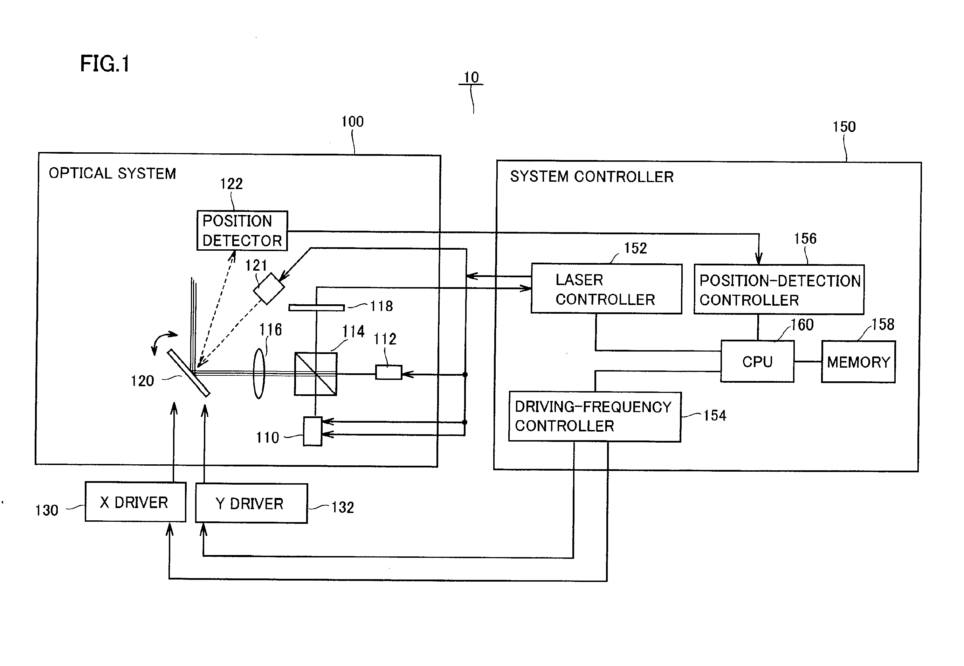

With reference to Fig. 1, an image display apparatus according to an embodiment of the present invention will be described. Fig. 1 is a block diagram showing a configuration of a laser projector 10 which is a mode of the image display apparatus. Laser projector 10 includes an optical system 100, a system controller 150, an X driver 130, and a Y driver 132.

Optical system 100 includes a red blue laser 110, a green laser 112, a polarization beam splitter 114, a collimator lens 116, a laser power detector 118 a scanner mirror 120, a laser 121, and a position detector 122. System controller 150 includes a laser controller 152, a driving-frequency controller 154, a position-detection controller 156, a memory 158, and a CPU (Central Processing Unit) 160.

Laser light of each color emitted by red blue laser 110 is reflected off polarization beam splitter 114 to enter collimator lens 116. Laser light emitted by green laser 112 passes through polarization beam splitter 114 to enter collimator lens 116.

Upon receipt of laser light from polarization beam splitter 114, laser power detector 118 detects power levels of laser light emitted from red blue laser 110 and green laser 112. The power levels are input to laser controller 152. Laser controller 152 controls power of the respective lasers based on the power levels and a command received from CPU 160.

Scanner mirror 120 reflects laser light of each color passed through collimator lens 116 toward a predetermined projection direction. Scanner mirror 120 is driven in the horizontal and vertical directions by X driver 130 and Y driver 132.

Laser 121 irradiates scanner mirror 120 with laser light. The reflected light from scanner mirror 120 enters position detector 122 Position detector 122 outputs a signal for identifying the position of scanner mirror 120 based on that laser light. This signal is input to position-detection controller 156.

In system controller 150, CPU 160 is configured to control laser controller 152 and driving-frequency controller 154 based on an output from position-detection controller 156. CPU 160 causes positional information calculated based on the output from position-detection controller 156 to be stored in memory 158. Memory 158 is implemented by a nonvolatile memory such as a flash memory.

Laser controller 152 is configured to control red blue laser 110, green laser 112 and laser 121 based on an output from CPU 160 or an output from laser power detector 118. Laser controller 152 transmits the output from laser power detector 118 to CPU 160.

Driving-frequency controller 154 is configured to control X driver 130 and Y driver 132 based on an output from CPU 160. More specifically, driving-frequency controller 154 provides X driver 130 and Y driver 132 with a signal having a frequency that defines driving in the horizontal direction (hereinafter also referred to as a "horizontal driving signal") and a signal having a frequency that defines driving in the vertical direction (hereinafter also referred to as a "vertical driving signal") so as to drive scanner mirror 120 in the horizontal or vertical direction in accordance with a command from CPU 160. X driver 130 drives scanner mirror 120 in the horizontal direction based on the horizontal driving signal. Y driver 132 drives scanner mirror 120 in the vertical direction based on the vertical driving signal.

Position-detection controller 156 performs AD (Analog to Digital) conversion on positional information of scanner mirror 120 based on an output from position detector 122, and transmits the digital data obtained by conversion to CPU 160. CPU 160 causes the position of scanner mirror 120 to be detected based on the digital data, and controls laser controller 152 or driving-frequency controller 154 according to the result of detection.

A vertical driving frequency and a horizontal driving frequency are previously defined based on the size of scanner mirror 120, the projection direction, and behavior properties of X driver 130 or Y driver 132. In an aspect, data giving the vertical driving frequency and data giving the horizontal driving frequency are stored in memory 158.

In the present embodiment, system controller 150 is partially or entirely implemented by hardware such as a combination of circuit elements, or a processor for executing commands that achieve respective operations and a memory storing the commands.

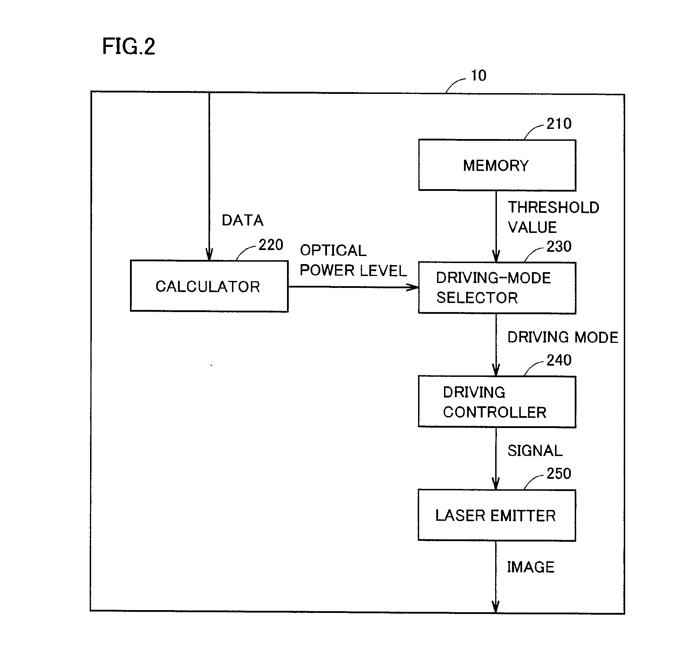

With reference to Fig. 2, the configuration of laser projector 10 will be described in detail. Laser projector 10 includes a memory 210, a calculator 220, a driving-mode selector 230, a driving controller 240, and a laser emitter 250.

Memory 210 stores a threshold value predetermined for changing the driving mode of the laser light source of laser projector 10. Calculator 220 calculates an optical power level for projecting an image, based on data given to laser projector 10. Driving-mode selector 230 selects a mode for driving the laser light source based on the threshold value stored in memory 210 and the optical power level calculated by calculator 220. A driving mode to be selected includes, but not limited to, PAM (Pulse Amplitude Modulation) driving, PWM (Pulse Width Modulation) driving, and CW (Continuous Wave) driving. As used herein, the term "continuous" means that no modulation takes place within a pixel.

Driving controller 240 sends a signal to the laser light source in accordance with the driving mode selected by driving-mode selector 230. The laser light source emits light in accordance with the signal. More specifically, driving controller 240 turns on/off a switch provided on a current output path to red blue laser 110 and green laser 112 to control light emission from the respective lasers. Laser projector 10 projects an image based on an optical signal output from laser emitter 250.

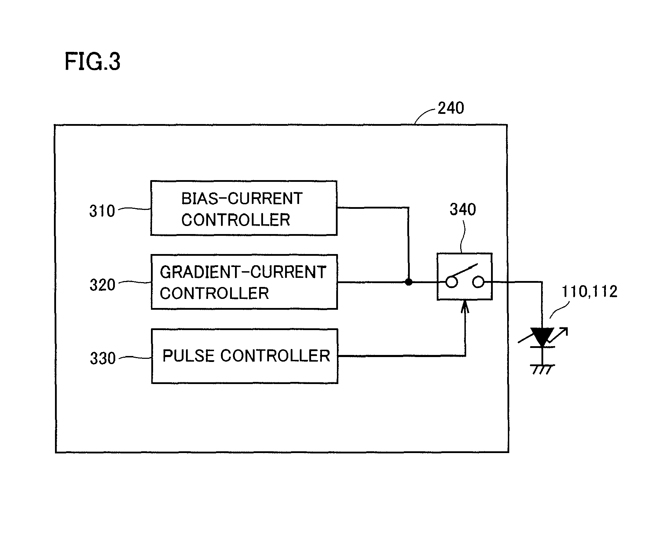

With reference to Fig. 3, driving control in laser projector 10 will now be described in detail. Fig. 3 is a block diagram showing a configuration of driving controller 240. Driving controller 240 includes a bias-current controller 310, a gradient-current controller 320, a pulse controller 330, and a switch 340.

Bias-current controller 310 supplies a constant bias current value previously defined to the respective lasers from a power supply supplied to laser projector 10. Gradient-current controller 320 controls an optical power level in proportion to a video signal based on data given to laser projector 10 for displaying an image. Pulse controller 330 turns on/off switch 340 based on a duty ratio defined in accordance with a selected driving mode. As a result, a bias current and a gradient current are supplied to each of red blue laser 110 and green laser 112.

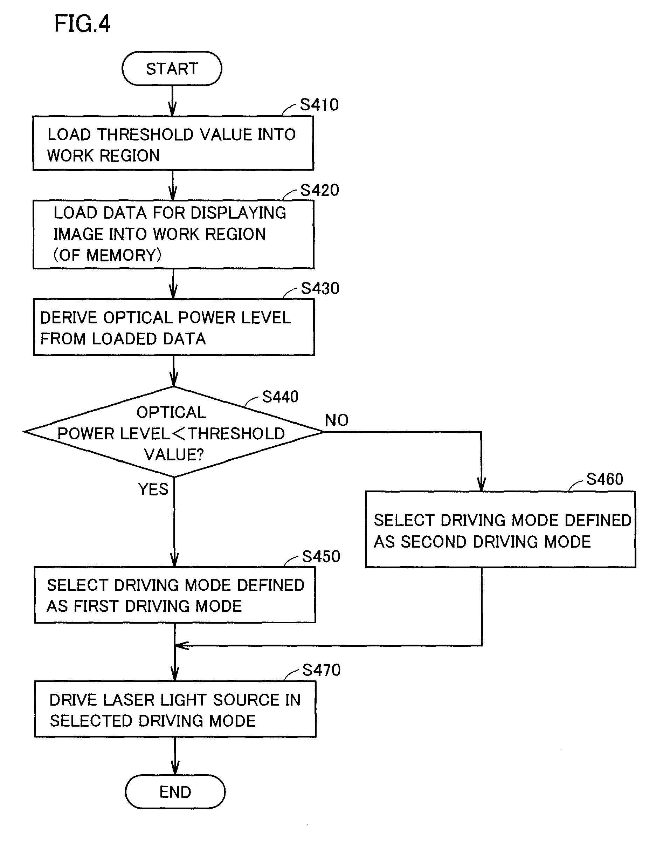

With reference to Fig. 4, a control structure of laser projector 10 according to the present embodiment will now be described. Fig. 4 is a flow chart showing a part of a series of process executed by system controller 150 included in laser projector 10.

At step S410, CPU 160 of system controller 150 causes the threshold value stored in memory 158 to be loaded into an internal work region of memory 158. At step S420, CPU 160 causes data given to laser projector 10 as data for displaying an image to be loaded into the work region.

At step S430, CPU 160 causes an optical power level to be derived from the loaded data. At step S440, CPU 160 determines whether or not the optical power level falls below the threshold value. When CPU 160 determines that the optical power level falls below the threshold value (YES at step S440), CPU 160 causes the control to proceed into step S450. Otherwise (NO at step S440), CPU 160 causes the control to proceed into step S460.

At step S450, CPU 160 selects a driving mode (driving form) previously defined as a first driving mode of laser projector 10. More specifically, CPU 160 selects one of the PAM driving mode and the PWM driving mode. At step S460, CPU 160 selects a driving mode previously defined as a second driving mode of laser projector 10. More specifically, CPU 160 selects one of the PAM driving mode, the PWM driving mode, and the CW driving mode. Driving forms actually used by laser projector 10 are previously specified by a manufacturer while manufacturing laser projector 10, and the specified driving forms are provided. The specified driving modes are stored in memory 158. CPU 160 executes a command in accordance with a driving form, referring to the stored data. In another aspect, a driving form selected as the first driving mode or the second driving mode may be changed subsequently.

It is to be noted that the first driving mode and the second driving mode each include the PAM driving mode and the PWM driving mode, however, they differ as will be described below. First, in the PAM driving, output modulation takes place by controlling the amplitude of current. More specifically, with respect to setting of the duty ratio, the duty ratio in the second driving mode is set higher than that in first driving mode. Accordingly, as a result, the second driving mode may include a driving mode (CW driving) where the duty ratio is 100%, whereas the first driving mode will not include the CW driving.

In the PWM driving, output modulation takes place by changing the setting of a current value. More specifically, a current value in the second driving mode is set higher than that in first driving mode. Accordingly, the first driving mode and the second driving mode differ in specific output mode even when an identical driving form is used (PWM driving or PAM driving). Thus, control can be exerted in accordance with an intended purpose.

At step S470, laser controller 152 supplies a signal to red blue laser 110 and green laser 112 in accordance with the driving mode selected by CPU 160.

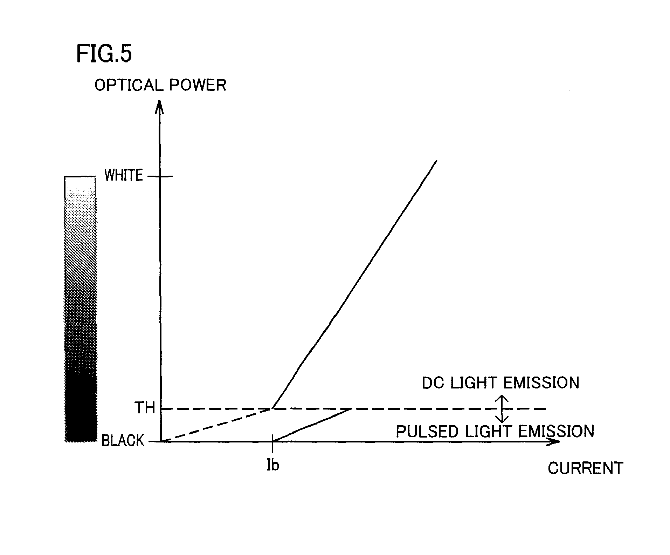

With reference to Fig. 5, operation properties of laser projector 10 will be described.

Laser projector 10 is configured to operate at least at a bias current value Ib or more. In this case, when the optical power level is lower than or equal to a predetermined threshold value TH, laser projector 10 is configured to emit pulsed light. When the optical power level based on a video signal exceeds threshold value TH, laser projector 10 is configured to change the driving mode of laser emission from pulsed light emission to DC light emission, to thereby supply a current higher than or equal to bias current value Ib or more to each of red blue laser 110 and green laser 112. Timing of changing the driving mode may include the time at which threshold value TH is reached.

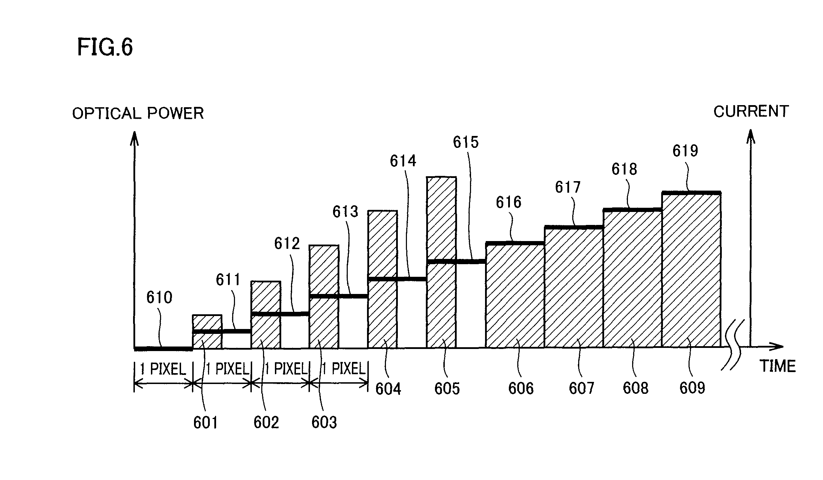

With reference to Fig. 6, the operation properties of laser projector 10 will be described in more detail.

Fig. 6 explains a case in which ten pixels are displayed by light emission. For example, an optical power level 610 is necessary for a pixel requiring the lowest value of optical power level, for example. In this case, a current output value will be "0", and thus each laser light source is merely supplied with bias current value Ib.

When displaying, by light emission, respective pixels requiring optical power levels 611, 612, 613, 614, and 615, current output values 601, 602, 603, 604, and 605 are given to each laser light source. In this case, when the duty ratio is set at 50%, for example, as is clear from Fig. 6, each laser light source emits light for one half the whole light emission time. Then, when the optical power level increases further to display, by light emission, respective pixels requiring optical power levels 616, 617, 618, and 619, for example, laser projector 10 changes the driving mode from pulsed light emission to DC light emission. Laser projector 10 outputs current output values 606, 607, 608, and 609 to each laser light source in order to display the respective pixels by light emission. In this case, as is clear from Fig. 6, driving control is executed for all of time durations provided for displaying the respective pixels by light emission (i.e., at a duty ratio of 100%).

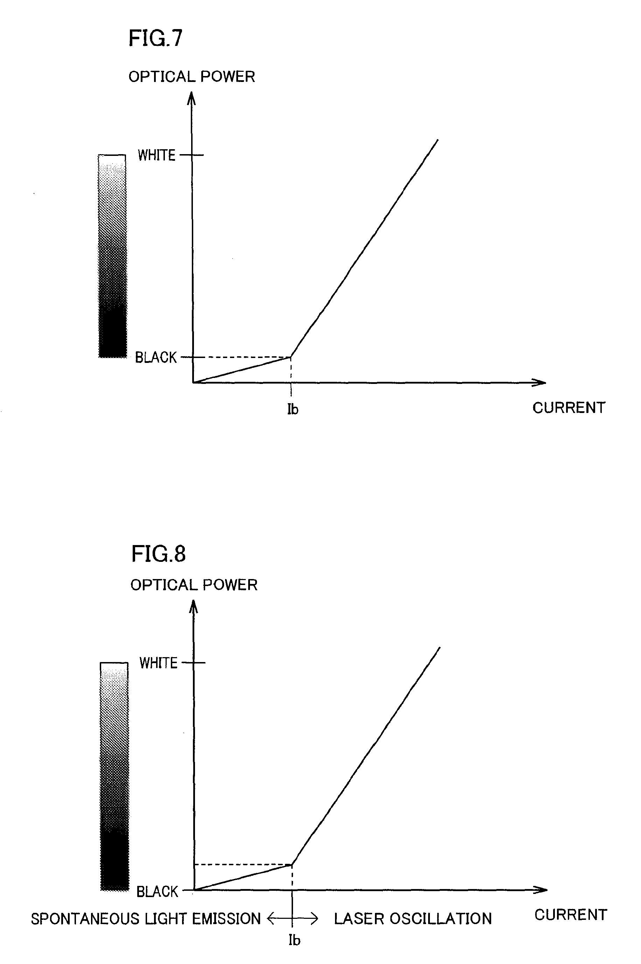

With reference to Figs. 7 and 8, a difference between laser projector 10 according to the present embodiment and a laser projector according to another mode will now be described. Fig. 7 shows driving properties when bias current value Ib is used as a reference value for displaying an optical power level of black light. In this case, a current value given to a laser light source increases linearly starting from bias current value Ib. Therefore, the linearity is also ensured in light emission by the laser light source. In such a mode, however, an optical power itself is high when the optical power level is black, resulting in reduced contrast with another color.

Fig. 8 shows a case where a current value lower than bias current value Ib is used for emitting black light. In this case, the optical power level for emitting black light increases, resulting in higher contrast. With such light emitting operation, however, spontaneous light emission takes place at a current value lower than bias current value Ib, causing light to diffuse, so that focusing on a spot projected by the laser projector cannot be obtained. As a result, the resolution is reduced. When exceeding bias current value Ib, a mode of laser oscillation is brought about, where the relationship of current value with optical power can no longer maintain the linearity. Therefore, to maintain the linearity in optical power, resolution provided by gradient-current controller 320 needs to be increased, which may result in a complicated control mechanism.

However, according to the laser projector of the present embodiment, a current value higher than or equal to a bias current value is always used when emitting light. This prevents increase in spot size due to spontaneous light emission, and achieves an improved contrast without degrading the resolution. Accordingly, gray-scale display with favorable contrast, resolution and linearity can be achieved.

In addition, the use of the PAM driving, the PWM driving, and the like as control modes of laser driving eliminates the need to flow a current smaller than or equal to a threshold value (bias current value) when no laser light is emitted, which achieves reduced power consumption.

Although the present invention has been described and illustrated in detail, it is clearly understood that the same is by way of illustration and example only and is not to be taken by way of limitation, the scope of the present invention being interpreted by the terms of the appended claims.

## Claims

1. An image display apparatus comprising:
a laser light source (110, 112, 121); and
a controller (150) for controlling driving of said laser light source, said controller being configured to change a driving form of said laser light source based on an optical power level in accordance with data given to said image display apparatus for displaying an image and on a set threshold value.

2. The image display apparatus according to claim 1, wherein said controller is configured to drive said laser light source at a current value higher than or equal to a bias current value.

3. The image display apparatus according to claim 1, wherein
said driving form includes a first driving mode and a second driving mode,
said controller is configured to drive said laser light source in said first driving mode when said optical power level falls below said threshold value, and
said controller is configured to drive said laser light source in said second driving mode when said optical power level exceeds said threshold value.

4. The image display apparatus according to claim 3, wherein
said first driving mode includes one of PAM (Pulse Amplitude Modulation) driving and PWM (Pulse Width Modulation) driving,
said second driving mode includes one of PAM driving, PWM driving, and CW (Continuous Wave) driving,
a duty ratio in said PAM driving as said second driving mode is higher than a duty ratio in said PAM driving as said first driving mode, and
a current value for said PWM driving as said second driving mode is higher than a current value for said PWM driving as said first driving mode.

5. A method for controlling an image display apparatus, comprising the steps of:
loading data for displaying an image onto said image display apparatus; and
driving a laser light source by changing a driving form of said laser light source based on an optical power level in accordance with said data and on a set threshold value.

6. The method according to claim 5, wherein said step of driving includes a step of driving said laser light source at a current value higher than or equal to a bias current value.

7. The method according to claim 5, wherein
said driving form includes a first driving mode and a second driving mode, and said step of driving includes:
driving said laser light source in said first driving mode when said optical power level falls below said threshold value, and
driving said laser light source in said second driving mode when said optical power level exceeds said threshold value.

8. The method according to claim 7, wherein
said first driving mode includes one of PAM (Pulse Amplitude Modulation) driving and PWM (Pulse Width Modulation) driving,
said second driving mode includes one of PAM driving, PWM driving, and CW (Continuous Wave) driving,
a duty ratio in said PAM driving as said second driving mode is higher than a duty ratio in said PAM driving as said first driving mode, and
a current value for said PWM driving as said second driving mode is higher than a current value for said PWM driving as said first driving mode.
